# FASCICULE DE BREVET EUROPEEN

(11) **EP 0 618 505 B1**
(45) Date de publication et mention de la délivrance du brevet: **24.11.2004**
(21) Numéro de dépôt: 94400700.4
(22) Date de dépôt: 31.03.1994
(51) Int. Cl.: G03F 7/20, G03F 9/00

(54) **Installation d'exposition à la lumière d'une plaque de circuit imprimé double face à travers des clichés**
Vorrichtung zur Belichtung einer doppelseitigen Plattenschaltung durch Druckplatten
Device for exposing to light a double sided circuit board plate through printing plates

(30) Priorité: 31.03.1993 FR 9303736
(43) Date de publication de la demande: 05.10.1994
(73) Titulaire: AUTOMA-TECH, F-27000 Evreux (FR)
(72) Inventeur: Sorel, Alain, F-27180 Les Baux Sainte Croix (FR); Charbonnier, Serge, F-27120 Chambray (FR); Laquerriere, Michel, F-27490 Ecardenville (FR)
(74) Mandataire: Dronne, Guy

(56) Documents cités:
- EP-A- 0 422 525
- WO-A-94/02807
- US-A- 4 677 303
- US-A- 4 764 791
- US-A- 5 337 151
- PATENT ABSTRACTS OF JAPAN vol. 12, no. 71 (P-673) 5 Mars 1988 & JP-A-62 211 657 (OAK SEISAKUSHO K. K.) 17 Septembre 1987
- Western Electric Technical Digest No 35 p.47-48 sides of a wafer July 1974
- SPECIFICATION INNERLAYER/OUTERLAYER EXPOSURE UNIT, juin 1992, référant à Opti-Beam 7557/8557 Automatic Load, Double Sided, Exposure System With Video Alignment
- OPTICAL RADIATION CORPORATION PURCHASE ORDER ACKNOWLEDGEMENT FOR HEWLETT-PACKARD GMBH, 09.09.92
- ELECTRONIC PACKAGING & PRODUCTION MAGAZINE, SPECIAL SUPPLEMENT, COVER SHEET AND TECHNICAL ABSTRACT, janvier 1993

## Description

La présente invention a pour objet une installation d'exposition à la lumière d'une plaque de circuit imprimé double face à travers des clichés.

On sait que, parmi les opérations nécessaires à la réalisation d'une carte de circuit imprimé, il intervient une étape d'insolation notamment pour la définition par photogravure de pistes conductrices. L'installation correspondante a pour fonction d'exposer aux ultraviolet pendant un temps donné des circuits imprimés recouverts d'un film ou d'une laque photosensible à travers un cliché pour insoler la partie correspondante de la laque ou du film photosensible.

Les machines de ce type permettant l'exposition aux ultraviolet d'une face de la plaque de circuit imprimé sont bien connues. Cependant, lorsque la plaque du circuit imprimé est du type double face, l'utilisation de telles machines est peu adaptée puisqu'elle nécessite le passage de la plaque à deux reprises dans la machine d'exposition, ce qui nécessite donc deux opérations, notamment de positionnement du cliché sur son support par rapport au circuit imprimé.

Pour remédier à cet inconvénient, on a déjà proposé une machine d'exposition à la lumière qui permet effectivement d'exposer à la lumière les deux faces du circuit imprimé.

Les documents Specification Opti-Beam 7557/8557, Document No. D 114 299 de Janvier 1992 et COVERSHEET AND TECHNICAL ABSTRACT daté de Janvier 1993 et publié dans Electronic Packaging and Production Magazine - supplément spécial, décrivent une machine pour exposer simultanément à un rayonnement lumineux les deux faces d'un PCB à travers deux clichés disposés de part et d'autre du PCB. Cette machine comporte des systèmes de positionnement des deux clichés par rapport au PCB.

Les documents Patent Abstracts of Japan Vol 12 No. 71 (P-673) du 5 mars 1988 et le JP-A-62 211 657 décrivent également une machine pour exposer simultanément à un rayonnement lumineux les deux faces d'un circuit imprimé à travers deux clichés. Pour permettre le positionnement des clichés par rapport au circuit imprimé, celui-ci est préfixé sur un cadre et c'est le cadre qui est déplacé pour obtenir le positionnement relatif.

Un objet de la présente invention est de fournir une installation qui permette l'exposition à la lumière, notamment aux ultraviolet, des deux faces du circuit imprimé simultanément à travers les deux clichés correspondants avec alignement relatif de deux clichés par rapport au circuit imprimé comportant des moyens améliorés de positionnement relatif du circuit imprimé et des clichés.

Pour atteindre ce but, l'installation d'exposition à la lumière d'une plaque de circuit imprimé double face à travers des clichés, comprend :
un premier support d'un cliché muni d'une marque de repérage de position ;
un deuxième support d'un cliché muni d'une marque de repérage de position ;
une source lumineuse ;
des moyens optiques pour diriger simultanément vers chaque support de cliché un faisceau lumineux à partir du faisceau émis par ladite source; et
des moyens pour disposer ledit circuit entre lesdits premier et deuxième supports de cliché, ledit circuit étant muni d'une marque de repérage de position ;
des moyens optiques pour détecter les erreurs de position entre ledit circuit et ledit deuxième support et entre ledit premier support et ledit deuxième support ou entre ledit circuit et ledit premier support à l'aide des marques de repérage ;
et elle se caractérise en ce qu'elle comprend en outre :
   des moyens disposés à l'extérieur de l'ensemble constitué par lesdits supports et ledit circuit et du côté dudit deuxième support pour déplacer dans son plan ledit deuxième support par rapport audit premier support en fonction de l'erreur de position détectée ; et
   des moyens disposés à l'extérieur de l'ensemble constitué par lesdits supports et ledit circuit et du côté dudit deuxième support pour déplacer dans son plan ledit circuit par rapport au deuxième support en fonction de l'erreur de position détectée, lesdits moyens comprenant un premier et un deuxième doigt de déplacement qui peuvent être déplacés selon deux directions orthogonales parallèles audit circuit, ledit circuit comportant deux orifices, l'extrémité de chacun des doigts étant apte à pénétrer dans un desdits orifices ; et
   des moyens pour déplacer perpendiculairement à son plan ledit premier support vers ledit deuxième support et ledit circuit.

On comprend que, grâce à l'installation selon l'invention, on réalise la vérification optique des positions relatives du premier et du deuxième cliché et du circuit imprimé à exposer et on corrige les erreurs de positionnement grâce à des moyens de déplacement agissant sur le circuit et le deuxième support, ce qui permet de diriger simultanément un faisceau lumineux vers chacun des clichés de manière à réaliser simultanément l'exposition des deux faces du circuit imprimé au faisceau lumineux après que celui-ci ait traversé respectivement le premier et le deuxième cliché. Il n'y a donc qu'une seule opération de positionnement relatif des deux clichés et du circuit imprimé.

Selon un mode préféré de mise en oeuvre de l'invention, les moyens de déplacement du circuit par rapport audit deuxième support comprennent un premier et un deuxième doigt de déplacement qui peuvent être déplacés indépendamment l'un de l'autre par rapport audit deuxième support, chaque doigt pouvant être déplacé suivant deux directions orthogonales parallèles audit circuit, ledit circuit comportant deux orifices, l'extrémité de chacun des doigts étant apte à pénétrer dans un desdits orifices.

On comprend que, grâce à la présence des deux doigts, qui peuvent pénétrer dans des orifices correspondants du circuit, ces doigts étant mobiles par rapport au deuxième support de cliché. Il est possible de positionner avec une grande précision à partir des informations fournies par les moyens optiques de détection d'erreur de position le circuit par rapport au deuxième support bien que le circuit ne puisse être manipulé par sa périphérie.

D'autres caractéristiques et avantages de la présente invention apparaîtront mieux à la lecture de la description qui suit de plusieurs modes de réalisation de l'invention donnés à titre d'exemples non limitatifs. La description se réfère aux figures annexées sur lesquelles :
- la figure 1 est une vue en élévation de l'ensemble de l'installation d'exposition à la lumière ;
- la figure 2 est une vue de côté de l'installation montrant plus particulièrement sa partie optique ;
- la figure 3 est une vue de face de la chambre d'exposition ;
- la figure 4 est une vue en coupe selon la ligne IV-IV de la figure 3 ;
- la figure 5 est une vue de dessous de la figure 3 ;
- les figures 6a et 6b illustrent un premier mode de détection des erreurs de positionnement entre le circuit et les clichés ;
- les figures 7a, 7b et 7c illustrent un deuxième mode de réalisation de la détection des erreurs de positionnement entre le circuit et les deux clichés ; et
- les figures 8a, 8b et 8c illustrent un troisième mode de réalisation de la détection des erreurs de positionnement entre les deux clichés et le circuit imprimé.

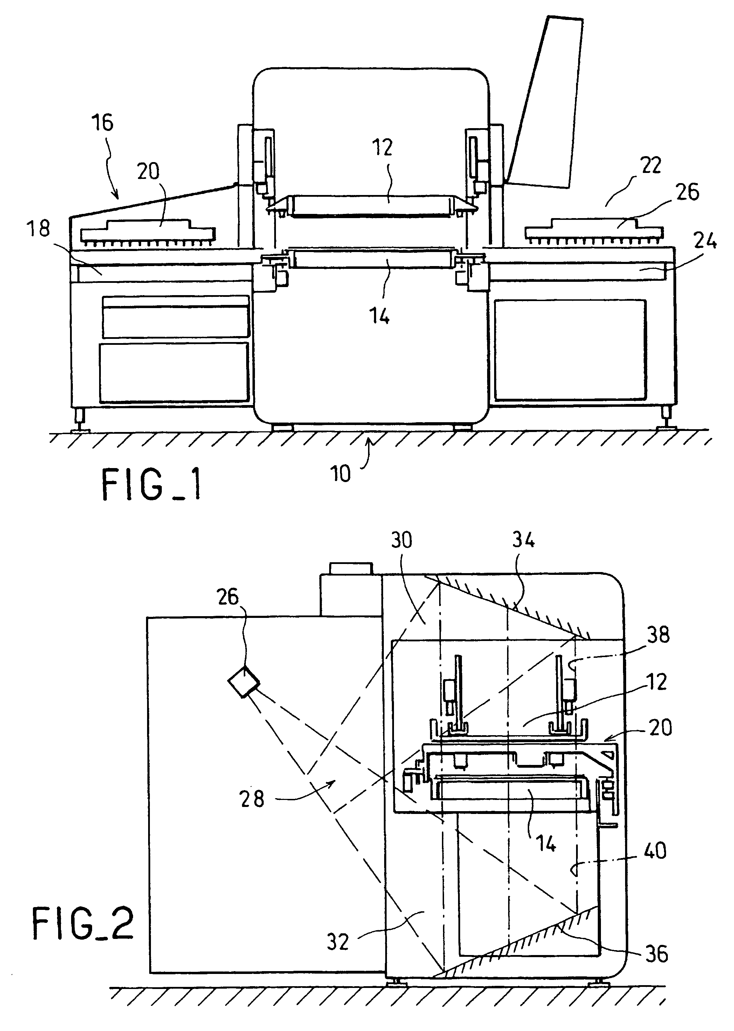

En se référant tout d'abord aux figures 1 et 2, on va décrire l'ensemble de l'installation d'exposition à la lumière des circuits imprimés.

Cette installation comprend une chambre d'exposition 10 comportant essentiellement un support supérieur de cliché 12 et un support inférieur de cliché 14. Comme on l'expliquera plus en détails ultérieurement, le support supérieur 12 est mobile selon la direction verticale alors que le support 14 est sensiblement immobile selon la direction verticale mais peut être déplacé dans un plan horizontal. L'installation comporte également une station de chargement des circuits à insoler 16. Cette station de chargement comprend principalement un convoyeur 18 d'amenée des circuits imprimés et un chariot 20 permettant le transfert des circuits imprimés de la station de chargement 16 vers la chambre d'exposition 10. Ce chariot est de façon connue de préférence du type à ventouses. La zone de déchargement 22 est essentiellement constituée par un convoyeur 24 qui permet l'évacuation des circuits imprimés après leur exposition et par un chariot de transfert 26 identique au chariot 20 qui permet de transférer les circuits imprimés de la chambre d'exposition 10 à la station de déchargement 22 après l'insolation du circuit imprimé.

La figure 2 montre que l'installation comprend également une source lumineuse 26, typiquement une source ultraviolet, un premier système optique 28 qui permet d'élaborer deux faisceaux lumineux divergents 30 et 32 et deux miroirs paraboliques 34 et 36 qui réfléchissent respectivement les faisceaux incidents 30 et 32 divergents selon deux faisceaux parallèles 38 et 40 qui sont dirigés respectivement vers le support de cliché supérieur 12 et le support de cliché inférieur 14. Sur cette figure, on a également représenté le chariot de transfert 20 dans sa position correspondant à la dépose du circuit imprimé sur le support de cliché inférieur 14.

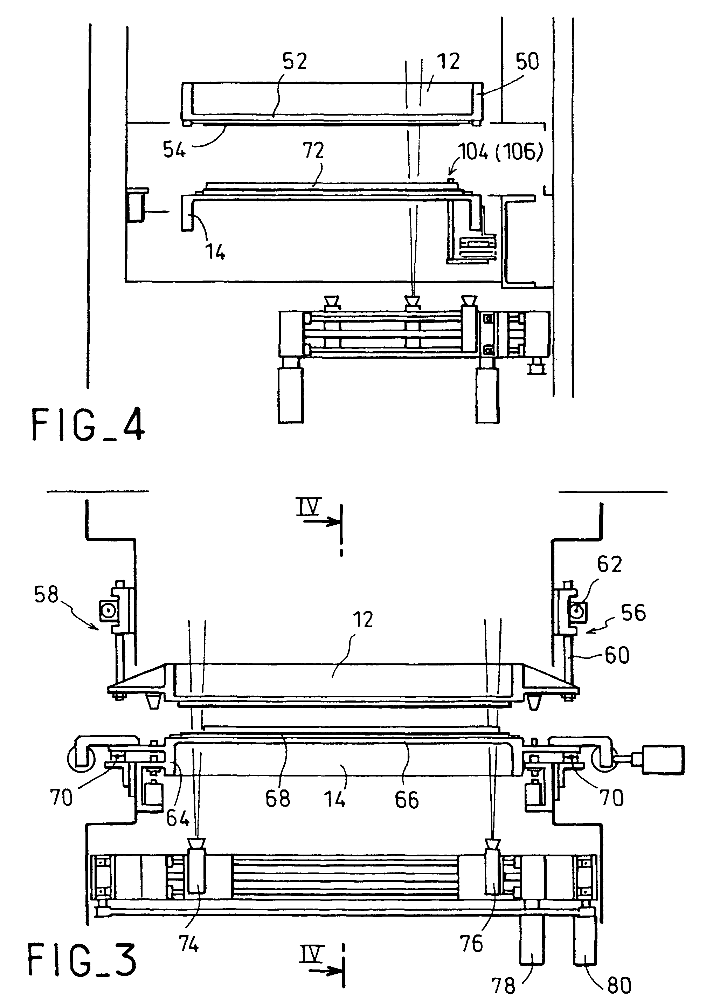

En se référant maintenant plus particulièrement aux figures 3 à 5, on va décrire la partie de la chambre d'exposition qui permet de positionner correctement le cliché supérieur, le cliché inférieur et le circuit imprimé à exposer avant l'insolation de celui-ci.

Comme cela est bien connu, le support de cliché supérieur est constitué par un cadre 50 qui supporte une vitre 52. Cette vitre 52 est munie d'une rainure reliée à un système de dépression permettant de maintenir en place par rapport à la vitre 52 le cliché supérieur 54. Comme le montre mieux la figure 3, le support de cliché supérieur 12 est mobile selon la direction verticale par l'intermédiaire de deux systèmes d'élévation 56 et 58 constitués par exemple par un système à crémaillère 60 et à pignon denté 62.

De la même manière, le support inférieur de cliché 14 est constitué par un cadre 64 supportant une vitre 66. Cette vitre 66 est munie d'une rainure reliée à un système de dépression pour permettre la fixation d'un cliché inférieur 68 sur la vitre inférieure 66.

Le cadre inférieur 64 est sensiblement immobile selon la direction verticale. En revanche, il est mobile dans son plan horizontal afin de permettre son positionnement par rapport au support supérieur 12 et donc le positionnement du cliché inférieur 68 par rapport au cliché supérieur 54. Pour cela le cadre inférieur 64 repose par sa périphérie sur quatre systèmes de palier à billes tels que 70. Le cadre 64 peut ainsi se déplacer dans son plan horizontal, selon les directions orthogonales X et Y ainsi qu'angulairement selon l'angle θ.

Comme le montre mieux la figure 4, en position d'attente, le support supérieur 12 est en position relevée pour permettre le passage du chariot de transfert 20 avec le circuit imprimé entre les deux supports de clichés. Ce circuit imprimé est déposé sur le cliché inférieur 68. On comprend que le problème est de positionner convenablement les clichés inférieur 68 et supérieur 54 ainsi que le circuit imprimé à insoler 72. Pour cela l'installation comporte des moyens de détection des erreurs de positionnement relatif de ces trois éléments et des moyens de déplacement dans un plan horizontal du support inférieur 14 et du circuit imprimé 72 afin de corriger les éventuelles erreurs de positionnement. En revanche, comme on l'a expliqué le support supérieur 12 et donc le cliché supérieur 54 sont immobiles dans un plan horizontal. On comprend qu'ainsi le cliché supérieur 54 va servir de référence de position pour ajuster la position du circuit imprimé 72 et du cliché inférieur 68.

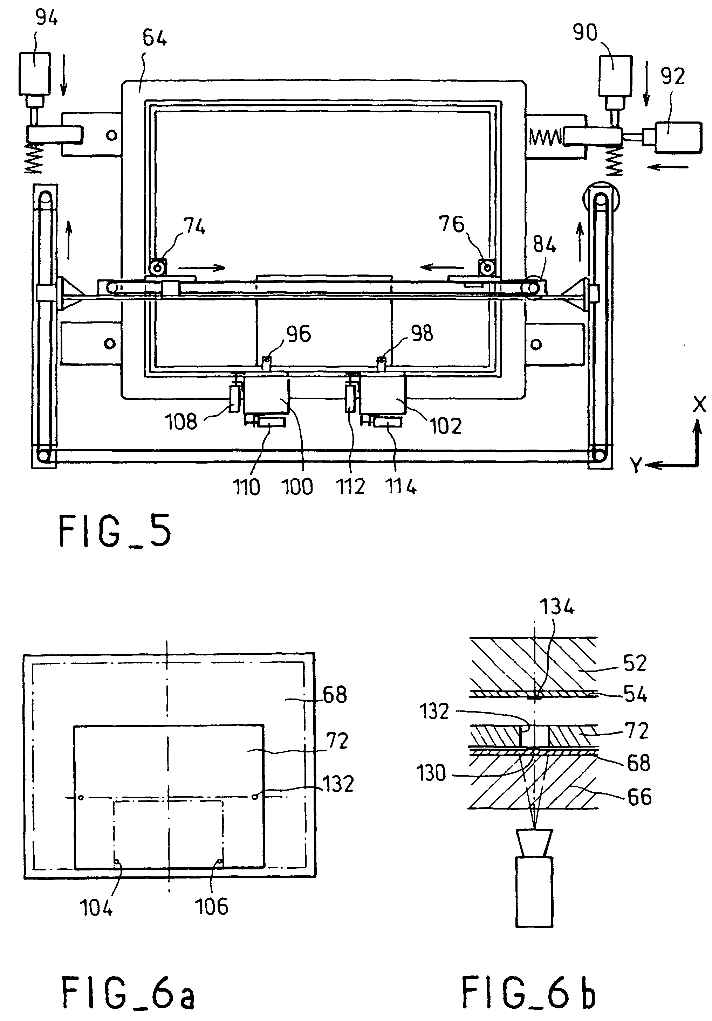

La détection des éventuelles erreurs de positionnement est réalisée à l'aide de deux caméras telles que 74 et 76 dont les axes sont perpendiculaires au plan des clichés et du circuit imprimé et qui permettent de détecter des décalages entre des éléments de repérage de position du cliché supérieur 54 du circuit imprimé 72 et du cliché inférieur 68. Compte tenu des dimensions différentes que peuvent présenter les circuits imprimés, ces caméras 74 et 76 sont mobiles selon les directions X et Y. Sur les figures 3 et 4 ainsi que sur la figure 5, on a représenté schématiquement les moteurs 78 et 80 permettant de commander le déplacement des deux caméras 74 et 76 selon les directions X et Y. Sur la figure 5, on voit que ces moteurs permettent de déplacer un support mobile 84 des caméras 74 et 76 selon la direction Y et de déplacer ce support mobile 84 selon la direction X de telle manière que les caméras puissent occuper n'importe quelle position dans la zone où peuvent se présenter les marques de repérage de position. On explicitera ultérieurement plus en détails le mode de réalisation de ces marques de repérage et la procédure de détection des erreurs de position à l'aide du traitement logiciel associé aux signaux recueillis par les caméras 74 et 76.

La figure 5 en particulier montre les moyens de déplacement du cadre inférieur 64 dans son plan horizontal. Ces moyens sont constitués de préférence par un premier moteur commandant le déplacement du cadre inférieur selon la direction X et un deuxième moteur 92 commandant le déplacement du cadre selon la direction Y. Les moyens de déplacement comportent de plus un troisième moteur 94 permettant le déplacement du cadre selon la direction X. On comprend que, si les moteurs 90 et 94 sont tous les deux commandés dans le même sens, on a un déplacement en translation du cadre 64 selon la direction X. Au contraire, si les moteurs 90 et 94 sont commandés dans des sens différents, on obtient un mouvement de rotation du cadre dans son plan horizontal. On comprend qu'ainsi, grâce aux moteurs 90, 92 et 94, il est possible de déplacer le support inférieur 14 et donc le cliché inférieur 68 dans toutes les positions dans son plan horizontal.

Le déplacement du circuit imprimé 72 par rapport au support inférieur 14 et donc par rapport au cliché inférieur 68 est réalisé de la manière suivante: deux doigts d'entraînement verticaux 96 et 98 sont montés sur des supports mobiles 100 et 102, ces supports étant mobiles par rapport au cadre inférieur 64 comme le montre mieux la figure 4. L'extrémité des doigts 96 et 98 peut pénétrer dans des orifices 104 et 106 ménagés dans le circuit imprimé 72. Les supports mobiles 100 et 102 sont reliés au cadre lui-même par l'intermédiaire respectivement des moteurs 108 et 110 pour le support 100 et 112 et 114 pour le support 102. En conséquence, par rapport au cadre 64, les doigts 96 et 98 peuvent se déplacer indépendamment l'un de l'autre selon les directions X et Y dans un plan horizontal. On comprend qu'ainsi il est possible de déplacer le circuit imprimé 72 par rapport au cliché inférieur 68 selon les directions X et Y et en rotation afin d'adapter la position du circuit imprimé par rapport au cliché inférieur en fonction des erreurs de positionnement détectées.

On comprend que les différents moteurs 90 à 94 pour le support inférieur 14 et 108 à 114 pour les doigts de déplacement du circuit imprimé 96 et 98 sont commandés en fonction des mesures de décalage de position effectuées par les caméras 74 et 76 selon le processus que l'on va expliciter ultérieurement.

La lecture à l'aide des caméras du décalage entre le circuit imprimé 72 et le cliché inférieur 68 se fait grâce à deux trous percés dans le circuit imprimé à exposer et deux mires tracées sur le cliché inférieur en même temps que le dessin de l'image à reproduire sur le circuit. Les deux caméras sont placées dans l'axe des trous et grâce à un logiciel d'analyse d'images on peut lire le décalage entre la mire du cliché et les orifices dans le circuit imprimé. Ces décalages sont ensuite traduits en signaux de commande envoyés aux moteurs assurant le déplacement des doigts de positionnement du circuit.

En ce qui concerne la lecture du décalage entre le circuit imprimé et le cliché supérieur, on peut utiliser deux méthodes. Selon une première méthode, la lecture du décalage se fait grâce à deux trous percés dans le circuit et à deux mires tracées sur le cliché supérieur en même temps que le dessin de l'image à reproduire sur le circuit. Les deux caméras placées dans l'axe des trous combinées à un logiciel d'analyse d'images permettent de lire le décalage entre mire et trou pour chacune des paires mire/trou. Ces décalages sont ensuite traduits en signaux de commande envoyés aux moteurs assurant le déplacement du cadre inférieur supportant le cliché inférieur qui assure simultanément le déplacement du circuit imprimé.

Selon une deuxième méthode, on mesure non pas le décalage du cliché supérieur par rapport au circuit mais le décalage du cliché supérieur par rapport au cliché inférieur. La lecture du décalage entre cliché supérieur et cliché inférieur se fait grâce à deux mires tracées sur chaque cliché en même temps que le dessin de l'image à reproduire sur le circuit. Deux caméras placées dans l'axe des mires et combinées à un logiciel d'analyse d'images permettent de lire le décalage entre mire supérieure et mire inférieure pour chacune des paires de mires. Ces décalages sont ensuite traduits en signaux de commande pour les moteurs assurant le déplacement du cadre supportant le cliché inférieur.

Les figures 6a et 6b illustrent la première méthode de positionnement du cliché supérieur par rapport au cliché inférieur. Le cliché inférieur 58 comporte deux mires telles que 130 en regard de trous tels que 132 ménagés dans le circuit imprimé 72. Ces trous sont de préférence percés au milieu du petit côté du circuit imprimé à 3 mm du bord. Le cliché supérieur 54 comporte également deux mires 134. Ce mode de repérage des décalages permet de minimiser les écarts possibles dus aux variations dimensionnelles du cliché à la suite de changement de température entre cliché et circuit. Les caméras 74 et 76 sont déplacées pour venir dans l'alignement des mires.

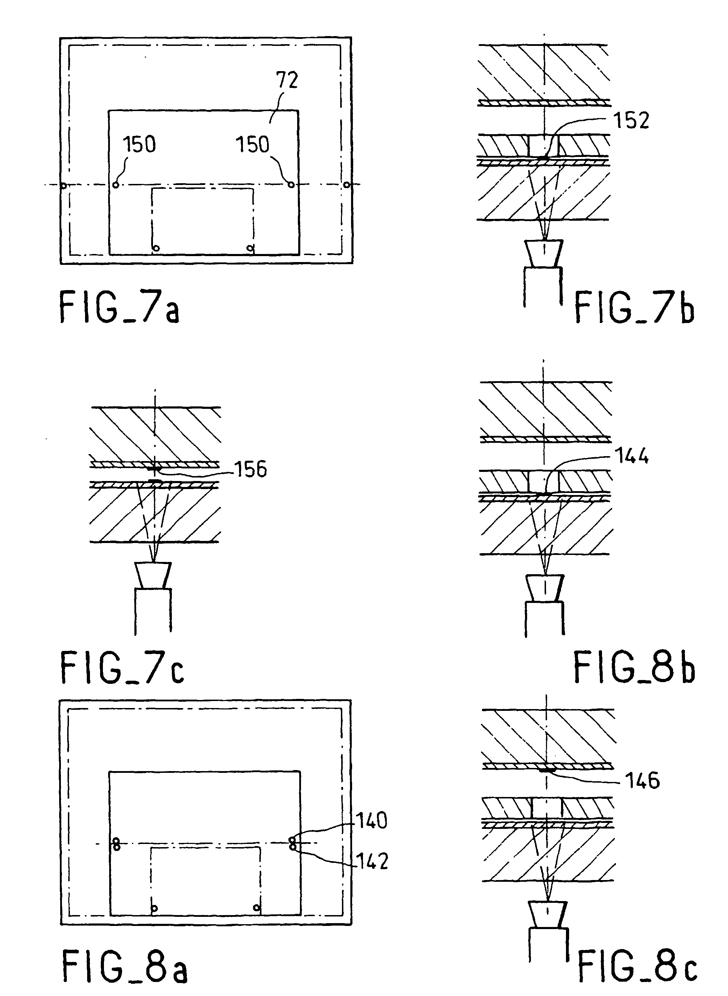

Selon une variante de ce premier mode de mise en oeuvre de l'invention illustrée par les figures 8a, 8b et 8c, les trous dans le circuit imprimé peuvent être dédoublés. Sur la figure 8a, ils ont été référencés 140 et 142. Le cliché inférieur comporte deux mires 144 en regard des trous 140 et le cliché supérieur comporte deux mires 146 disposées en regard des trous 142.

Les figures 7a à 7c illustrent la deuxième méthode de repérage des décalages. Le circuit 72 est percé de deux orifices de repérage 150. Le cliché inférieur comporte deux mires 152 en regard des trous 150. Le cliché supérieur comporte deux mires 156 en regard des mires 152 du cliché inférieur. Les caméras sont déplacées pour viser le décalage entre les mires inférieures 152 et les mires supérieures 156.

On va décrire maintenant le mode d'utilisation de l'installation décrite en référence aux figures 1 à 8 pour réaliser une exposition double face du circuit imprimé 72.

Dans une première phase, l'opérateur met en place les clichés sur les vitres des supports de cliché. Plus précisément, il pose le cliché inférieur 68 sur la vitre 66. Sur cette vitre, quatre pions collés correspondant à quatre trous du cliché assurent le bon positionnement de celui-ci. Puis il commande le système d'aspiration pour plaquer le cliché sur la vitre. L'opérateur pose le cliché supérieur 54 sur le cliché inférieur, le positionnement initial étant obtenu par les mêmes pions collés. Il commande alors la descente du support supérieur 12 de telle manière que la vitre supérieure 52 vienne en appui sur le cliché supérieur 54. L'opérateur commande alors le système d'aspiration de la vitre supérieure de telle manière que le cliché supérieur soit plaqué sur la vitre supérieure. Il commande alors la remontée du support supérieur 12 à l'aide des systèmes de remontée 56 et 58.

Après cette étape initiale, le chariot 20 transfère un circuit imprimé de la station de chargement 16 vers la chambre d'exposition 10. Le circuit imprimé 72 est séparé du chariot et repose ainsi sur le cliché inférieur 68. Des pions de positionnement solidaires de la vitre inférieure coopérant avec des orifices du cliché assurent un prépositionnement de celui-ci. Puis le support supérieur 12 est abaissé jusqu'à ce que la distance entre le cliché supérieur et la face supérieure du circuit imprimé soit de l'ordre de 2 mm. On commande alors les moteurs 78 et 80 pour amener les caméras 74 et 76 en alignement avec les trous de repérage ménagés dans le circuit imprimé 72. Les caméras envoient au dispositif de traitement les informations d'erreurs de position entre le cliché inférieur, le cliché supérieur et le circuit inférieur en mettant en oeuvre une des deux méthodes décrites en liaison avec les figures 6, 7 et 8.

Les informations d'erreur de position sont converties en signaux de commande pour actionner les moteurs 108 à 114 des doigts 96 et 98, ce qui assure le positionnement final du circuit imprimé par rapport au cliché inférieur et en signaux de commande pour actionner les moteurs 90 à 94, ce qui assure le positionnement final des deux clichés et du circuit imprimé. Puis les caméras 74 et 76 sont escamotées.

A l'aide des systèmes 56 et 58, on provoque la descente de la vitre supérieure 52 jusqu'à ce qu'elle vienne au contact de la face supérieure du cliché 72. On crée alors un vide entre les deux vitres pour assurer un contact interne entre le circuit imprimé et les deux clichés. On peut ainsi commander la source lumineuse 26 pour procéder à l'insolation des deux faces du circuit imprimé à travers les deux clichés.

Il est important de souligner que le positionnement des deux clichés de part et d'autre du circuit imprimé est rendu possible grâce au fait que les moyens de déplacement du support inférieur et du circuit imprimé sont disposés en totalité du côté du support inférieur et à l'extérieur du volume défini par les supports inférieur et supérieur. Ce résultat est atteint en particulier grâce à l'utilisation des doigts de déplacement du circuit imprimé, ces doigts étant disposés du même côté du support inférieur que les moteurs de déplacement du support inférieur.

Il va de soi que les rôles des supports inférieur et supérieur pourraient être permutés. Le support supérieur étant fixe selon la direction verticale et mobile dans son plan alors que le support inférieur serait mobile verticalement. Bien entendu, dans ce cas, les doigts de déplacement du circuit imprimé devraient être disposés au-dessus du support supérieur et traverser celui-ci.

## Revendications

1. Installation d'exposition à la lumière d'une plaque de circuit imprimé double face à travers des clichés, comprenant :
un premier support (12) d'un cliché (54) muni d'une marque de repérage de position ;
un deuxième support (14) d'un cliché (68) muni d'une marque de repérage de position ;
une source lumineuse (26) ;
des moyens optiques (28, 34, 36) pour diriger simultanément vers chaque support de cliché un faisceau lumineux à partir du faisceau émis par ladite source ; et
des moyens pour disposer ledit circuit (72) entre lesdits premier et deuxième supports de cliché, ledit circuit étant muni d'une marque de repérage de position ;
des moyens optiques (74, 76) pour détecter les erreurs de position entre ledit circuit et ledit deuxième support et entre ledit premier support et ledit deuxième support ou entre ledit circuit et ledit premier support à l'aide des marques de repérage ;
**caractérisée en ce qu'**elle comprend en outre :
des moyens (90, 92, 94) disposés à l'extérieur de l'ensemble constitué par lesdits supports et ledit circuit et du côté dudit deuxième support pour déplacer dans son plan ledit deuxième support par rapport audit premier support en fonction de l'erreur de position détectée ; et
des moyens (96, 98, 100, 102) disposés à l'extérieur de l'ensemble constitué par lesdits supports et ledit circuit et du côté dudit deuxième support pour déplacer dans son plan ledit circuit par rapport au deuxième support en fonction de l'erreur de position détectée, lesdits moyens comprenant un premier (96) et un deuxième doigt (98) de déplacement qui peuvent être déplacés selon deux directions orthogonales parallèles audit circuit, ledit circuit comportant deux orifices (104, 106), l'extrémité de chacun des doigts étant apte à pénétrer dans un desdits orifices ; et
des moyens (56, 58) pour déplacer perpendiculairement à son plan ledit premier support vers ledit deuxième support et ledit circuit.

2. Installation d'exposition à la lumière selon la revendication 1, **caractérisée en ce que** les marques de repérage sur chaque cliché (54, 68) comprennent deux mires (130, 134, 144, 146, 152, 156), **en ce que** les marques de repérage du circuit (72) comprennent deux orifices et **en ce que** les moyens optiques de détection comprennent deux caméras (74, 76) déplaçables dans un plan parallèle audit circuit selon deux directions orthogonales.

3. Installation d'exposition à la lumière selon l'une quelconque des revendications 1 et 2, **caractérisée en ce que** les moyens optiques (74, 76) de détection détectent les erreurs de position entre le deuxième cliché (68) et ledit circuit (72) et les erreurs de position entre ledit circuit (72) et le premier cliché (54).

4. Installation d'exposition à la lumière selon l'une quelconque des revendications 1 et 2, **caractérisée en ce que** les moyens optiques de détection (74, 76) détectent les erreurs de position entre le deuxième cliché (68) et ledit circuit (72) et les erreurs de position entre ledit deuxième cliché (68) et ledit premier cliché (54).

5. Installation d'exposition à la lumière selon l'une quelconque des revendications 1 à 4, **caractérisée en ce que** chaque support de cliché comprend un cadre (50, 64) et une vitre (52, 66) solidaires (12, 14) dudit cadre, chaque vitre recevant un desdits clichés (54, 68).

6. Installation d'exposition à la lumière selon l'une quelconque des revendications 1 à 5, **caractérisée en ce que** ledit premier support de cliché (12) est disposé au-dessus dudit deuixème support de cliché (14).

## Patentansprüche

1. Vorrichtung zur Belichtung einer doppelseitigen gedruckten Leiterplatte durch Klischees mit:
einem ersten Träger (12) eines Klischees (54), das mit einer Positionskennzeichnungsmarkierung versehen ist;
einem zweiten Träger (14) eines Klischees (68), das mit einer Positionskennzeichnungsmarkierung versehen ist;
einer Lichtquelle (26);
optischen Mitteln (28, 34, 36) zum gleichzeitigen Lenken eines Lichtstrahls zu jedem Klischeeträger, ausgehend von dem von der genannten Quelle gesendeten Strahl und
Mittel zum Anordnen der Leiterplatte (72) zwischen dem ersten und dem zweiten Klischeeträger, wobei die Leiterplatte mit einer Positionskennzeichnungsmarkierung versehen ist;
optischen Mitteln (74, 76) zum Erfassen der Positionsfehler zwischen der Leiterplatte und dem zweiten Träger und zwischen dem ersten Träger und dem zweiten Träger oder zwischen der Leiterplatte und dem ersten Träger mit Hilfe der Positionskennzeichnungsmarkierungen;
**dadurch gekennzeichnet, daß** sie ferner folgendes umfaßt:
Mittel (90, 92, 94), die außerhalb der Einheit angeordnet sind, die von den Trägern und der Leiterplatte gebildet wird, und auf der Seite des zweiten Trägers liegen, um den zweiten Träger zum ersten Träger in Abhängigkeit vom erfaßten Positionsfehler in seiner Ebene zu bewegen und
Mittel (96, 98, 100, 102), die außerhalb der Einheit angeordnet sind, die von den Trägern und der Leiterplatte gebildet wird und auf der Seite des zweiten Trägers liegen, um die Leiterplatte zum zweiten Träger in Abhängigkeit von dem erfaßten Positionsfehler in ihrer Ebene zu verschieben, wobei die Mittel einen ersten (96) und einen zweiten Finger (98) zum Bewegen umfassen, die gemäß zwei orthogonalen Richtungen bewegt werden können, die zur Leiterplatte parallel sind, wobei die Leiterplatte zwei Öffnungen (104, 106) umfaßt, wobei das Ende jedes der Finger in eine der Öffnungen eindringen kann, und
Mittel (56, 58) zum Bewegen des ersten Trägers zum zweiten Träger und zur Leiterplatte senkrecht zu seiner Ebene.

2. Vorrichtung zur Belichtung nach Anspruch 1, **dadurch gekennzeichnet, daß** die Kennzeichnungsmarkierungen auf jedem Klischee (54, 68) zwei Fadenkreuze (130, 134, 144, 146, 152, 156) umfassen, dadurch, daß die Kennzeichnungsmarkierungen der Leiterplatte (72) zwei Öffnungen umfassen, und dadurch, daß die optischen Erfassungsmittel zwei Kameras (74, 76) umfassen, die in einer Ebene parallel zur Leiterplatte nach zwei orthogonalen Richtungen bewegt werden können.

3. Vorrichtung zur Belichtung nach einem der Ansprüche 1 und 2, **dadurch gekennzeichnet, daß** die optischen Erfassungsmittel (74, 76) die Positionsfehler zwischen dem zweiten Klischee (68) und der Leiterplatte (72) und die Positionsfehler zwischen der Leiterplatte (72) und dem ersten Klischee (54) erfassen.

4. Vorrichtung zum Belichten nach einem der Ansprüche 1 und 2, **dadurch gekennzeichnet, daß** die optischen Erfassungsmittel (74, 76) die Positionsfehler zwischen dem zweiten Klischee (68) und der Leiterplatte (72) und die Positionsfehler zwischen dem zweiten Klischee (68) und dem ersten Klischee (54) erfassen.

5. Vorrichtung zum Belichten nach einem der Ansprüche 1 bis 4, **dadurch gekennzeichnet, daß** jeder Klischeeträger einen Rahmen (50, 64) und eine Glasscheibe (52, 66) umfaßt, die fest (12, 14) mit dem Rahmen verbunden ist, wobei jede Glasscheibe eines der Klischees (54, 68) aufnimmt.

6. Vorrichtung zum Belichten nach einem der Ansprüche 1 bis 5, **dadurch gekennzeichnet, daß** der erste Klischeeträger (12) über dem zweiten Klischeeträger (14) angeordnet ist.

## Claims

1. Apparatus for exposure to light of a double-sided printed circuit board through negatives, comprising:
- a first support (12) for a negative (54) provided with a position registration mark;
- a second support (14) for a negative (68) provided with a position registration mark;
- a light source (26);
- optical means (28, 34, 36) for simultaneously directing a light beam towards each negative support from the beam emitted by the said source; and
- means for arranging the said circuit (72) between the said first and second negative supports, the said circuit being provided with a position registration mark;
- optical means (74, 76) for detecting errors in positioning between the said circuit and the said second support and between the said first support and the said second support or between the said circuit and the said first support by means of the registration marks;
**characterised by** the fact that it also comprises:
means (90, 92, 94) arranged externally of the assembly formed by the said supports and the said circuit and on the side of the said second support to displace the said second support in its plane relative to the said first support as a function of the detected positioning error; and
- means (96, 98, 100, 102) arranged externally of the assembly formed by the said supports and the said circuit and on the side of the said second support to displace the said circuit in its plane relative to the second support as a function of the detected positioning error, the said means comprising a first (96) and a second (98) displacement finger which can be displaced in two directions at right-angles parallel with the said circuit, the said circuit including two orifices (104, 106), the end of each of the fingers being able to enter one of the said orifices; and
- means (56, 58) for displacing the said first support perpendicularly to its plane towards the said second support and the said circuit.

2. Apparatus for exposure to light as described in claim 1, **characterised by** the fact that the registration marks on each negative (54, 68) comprise two target marks (130, 134, 144, 146, 152, 156), by the fact that the registration marks of the circuit (72) comprise two orifices and by the fact that the optical detection means comprise two cameras (74, 76) displaceable in a plane parallel with the said circuit in two directions at right-angles.

3. Apparatus for exposure to light as described in any one of claims 1 and 2, **characterised by** the fact that the optical detection means (74, 76) detect positioning errors between the second negative (68) and the said circuit (72) and positioning errors between the said circuit (72) and the first negative (54).

4. Apparatus for exposure to light as described in any one of claims 1 and 2, **characterised by** the fact that the optical detection means (74, 76) detect positioning errors between the second negative (68) and the said circuit (72) and positioning errors between the said second negative (68) and the said first negative (54).

5. Apparatus for exposure to light as described in any one of claims 1 to 4, **characterised by** the fact that each negative support comprises a frame (50, 64) and a glazing (52, 66) rigidly attached (12, 14) to the said frame, each glazing receiving one of the said negatives (54, 68).

6. Apparatus for exposure to light as described in any one of claims 1 to 5, **characterised by** the fact that the said first negative support (12) is arranged above the said second negative support (14).
